# EUROPEAN PATENT SPECIFICATION

(11) **EP 4 291 849 B1**
(45) Date of publication and mention of the grant of the patent: **22.01.2025**
(21) Application number: 21709295.6
(22) Date of filing: 09.02.2021
(51) Int. Cl.: F28F 9/02, F28D 7/00

(54) **COMPACT TWO-PHASE HEAT EXCHANGER**
KOMPAKTER ZWEIPHASIGER WÄRMETAUSCHER
ÉCHANGEUR DE CHALEUR À DEUX PHASES COMPACT

(43) Date of publication of application: 20.12.2023
(73) Proprietor: RTX Corporation, Farmington, CT 06032 (US)
(72) Inventor: ALAHYARI, Abbas A., Glastonbury, Connecticut 06033 (US); TANGUDU, Jagadeesh Kumar, Windsor, Connecticut 06074 (US)
(74) Representative: Dehns
(86) International application number: PCT/US2021/017201
(87) International publication number: WO 2022/173416

(56) References cited:
- EP-A1- 3 124 771
- EP-A2- 1 916 399
- WO-A1-2017/117371
- WO-A1-2017/125361
- WO-A2-03/106946

## Description

### BACKGROUND

Exemplary embodiments pertain to the art of cooling systems and more specifically a compact two-phase heat exchanger.

Certain types of machines, such as high-power-density aviation-class electric motor and drives, generally may be thermally limited at high power ratings due to the generation of heat, which may limit their available performance. Thus, such machinery may utilize various types of cooling technologies to control the generation of heat. Two-phase cooling technologies may be an efficient approach for controlling heat generation. EP 1 916 399 A2 or WO 2017/117371 A1 disclose heat exchangers according to the preamble of claim 1.

### BRIEF DESCRIPTION

Disclosed is a heat exchanger including: an inlet manifold configured to receive a cooling fluid; a reservoir; first and second condenser arms connected between and that respectively fluidly couple the inlet manifold to the reservoir, so that fluid received at the inlet manifold travels from the inlet manifold into the reservoir; and an outlet pump having a pump inlet port coupled to the reservoir and having a pump outlet port, wherein the inlet manifold, the reservoir, the first and second condensers, in combination, form a continuous shape.

In embodiments, gravity, suction created by the pump or a combination of both draws the cooling fluid from the inlet manifold, through the condenser arms and into the reservoir.

In embodiments, the inlet manifold includes a manifold inlet port and first and second manifold outlet ports; the first and second condenser arms respectively extend from first and second condenser inlets to first and second condenser outlets; and wherein the first and second condenser inlets are fluidly coupled to respective ones of the first and second manifold inlet ports.

In embodiments, the reservoir extends from first and second reservoir inlets to a reservoir outlet; and the first and second reservoir inlets are fluidly coupled to respective ones of the first and second condenser outlets.

In embodiments, the pump inlet port is fluidly coupled to the reservoir outlet.

In embodiments, the first and second condenser arms includes one or more fluid conduction passageways that respectively extend between the first and second condenser inlets and the first and second condenser outlets.

In embodiments, the fluid conduction passageways includes fins.

In embodiments, the fins are formed from plates that define the first and second passageways or wherein the passageways are tubes and the fins contact and extend outwardly from the tubes.

In embodiments, one or more of the inlet manifold, the condenser arms and the reservoir are formed by an additive manufacturing process.

In embodiments, the heat exchanger is symmetric about an axis extending between the inlet manifold and the outlet pump.

In embodiments, the continuous shape of the heat exchanger is a ring shape.

In embodiments, the outlet pump is a variable speed pump.

In embodiments, the outlet pump is configured to disengage when a temperature of the cooling fluid at the pump inlet port is above a threshold or when a pressure of the cooling fluid is below a threshold.

In embodiments, the heat exchanger further includes a valve in fluid communication with the outlet pump, wherein the valve is configured to control the cooling fluid through it when a characteristic of the cooling fluid crosses a threshold.

In embodiments, the reservoir defines first and second reservoirs that respectively have first and second reservoir outlets, and the pump is circumferentially disposed between the first and second reservoirs and fluidly coupled to the first and second reservoir outlets

Further disclosed is an aircraft including: a motor; a motor cooling circuit extending through the motor; and a heat exchanger including: an inlet manifold configured to receive a cooling fluid; a reservoir; first and second condenser arms connected between and that respectively fluidly couple the inlet manifold to the reservoir, so that fluid received at the inlet manifold travels from the inlet manifold into the reservoir; and an outlet pump having a pump inlet port coupled to the reservoir and having a pump outlet port, wherein the inlet manifold, the reservoir, the first and second condensers, in combination, form a continuous shape.

Further disclosed is a method of directing fluid in a heat exchanger, including: directing a cooling fluid from an inlet manifold into first and second condenser arms; directing the cooling fluid out of the first and second condenser arms and into respective ones of first and second reservoirs; and directing the cooling fluid out of the first and second reservoirs and into an inlet port of an outlet pump having a pump outlet port, wherein the inlet manifold, the first and second reservoirs, the first and second condenser arms, in combination, form a continuous shape.

In embodiments, directing the cooling fluid from the inlet manifold into the first and second condenser arms includes: directing the cooling fluid out of first and second manifold outlet ports of the inlet manifold and into respective ones of first and second condenser inlets of the first and second condenser arms.

In embodiments, directing the cooling fluid out of the first and second condenser arms and into the reservoir includes: directing the cooling fluid out of first and second condenser outlets of the first and second condenser arms and into first and second reservoir inlets of the reservoir.

In embodiments, the method further includes: controlling the cooling fluid through the outlet pump based on one or more of a temperature and a pressure of the cooling fluid at the outlet pump.

### BRIEF DESCRIPTION OF THE DRAWINGS

The following descriptions should not be considered limiting in any way. With reference to the accompanying drawings, like elements are numbered alike:
FIG. 1 is a perspective view of an aircraft that includes aerodynamic surfaces where embodiments of the present invention can be implemented;
FIG. 2 shows a heat exchanger in fluid communication with a motor via a cooling circuit according to an embodiment;
FIG. 3 is a perspective view of the heat exchanger;
FIG. 4 is a front view of the heat exchanger;
FIG. 5 is a heat exchanger in fluid communication with a motor via a cooling circuit according to another embodiment;
FIG. 6 is a flowchart of a method of directing a cooling fluid through the heat exchanger of FIGS. 2-4; and
FIG. 7 is a flowchart of a method of directing a cooling fluid through the heat exchanger of FIG. 5.

### DETAILED DESCRIPTION

A detailed description of one or more embodiments of the disclosed apparatus and method are presented herein by way of exemplification and not limitation with reference to the Figures.

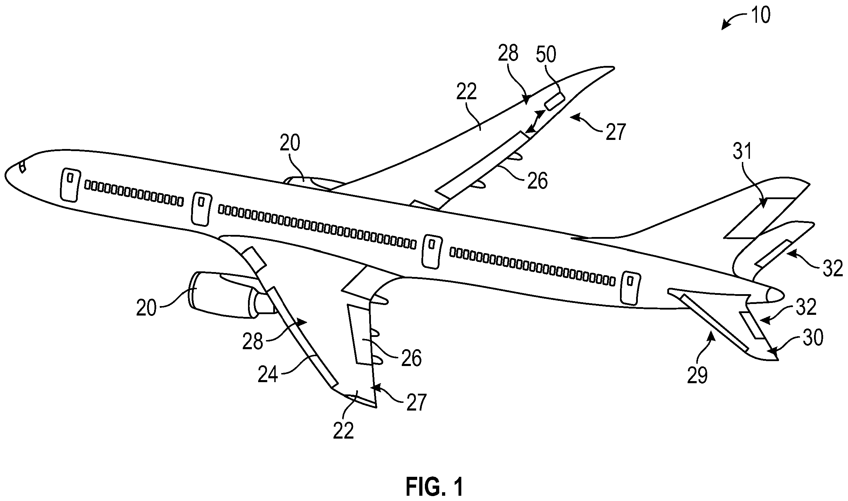

FIG. 1 illustrates an example of an aircraft 10 having aircraft engines surrounded by (or otherwise carried in) nacelles 20. The aircraft 10 includes two wings 22 that can each include one or more slats 24 and one or more flaps 26. The aircraft may further include ailerons 27, spoilers 28, horizontal stabilizer trim tabs 29, horizontal stabilizer 30 and rudder 31, and vertical stabilizer 32 (the tail structure being collectively referred to as an and empennage) each of which may be typically referred to as "control surfaces" as they are movable via one or more motors, including e.g., motor 50, under aircraft power systems.

As indicated, certain types of machines, including aviation-class electric motor and drives (such as the motor 50), may utilize various types of cooling technologies, including two-phase cooling technologies, to control the generation of heat in the motor 50. However, the availability of storage space around or adjacent to the motor 50 may limit the size of the cooling technologies.

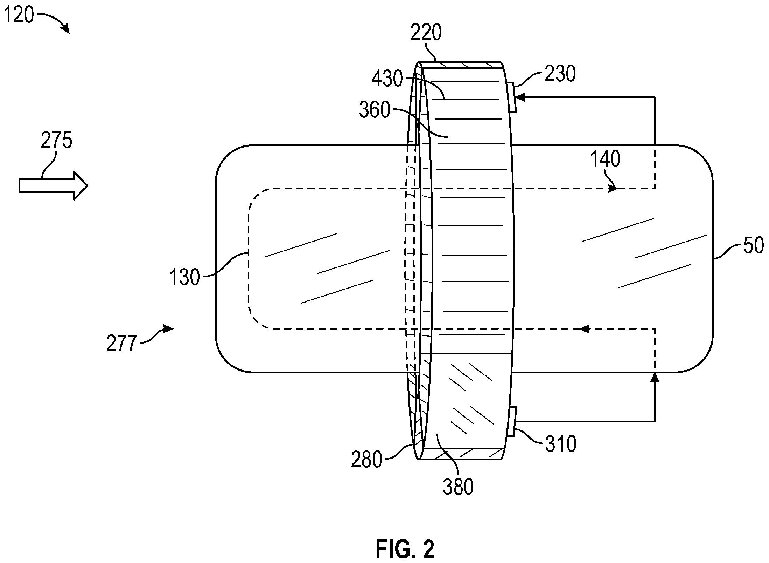

In view of the above concerns, as shown in FIGS. 2-4, a heat exchanger 120 is connected an external cooling circuit 130 (FIG. 2) and is configured to circulate a cooling fluid 140 to the external cooling circuit 130. In one embodiment, the cooling fluid 140 is a coolant, which may be a refrigerant such as but not limited to any of hydrofluoroolefins (HFOs), hydrofluorocarbons (HFCs), hydrofluoroethers (HFEs), chlorofluorocarbons (CFCs) or other phase-change fluids. In one embodiment the external cooling circuit 130 may be a motor cooling circuit of a motor 50 (FIG. 2).

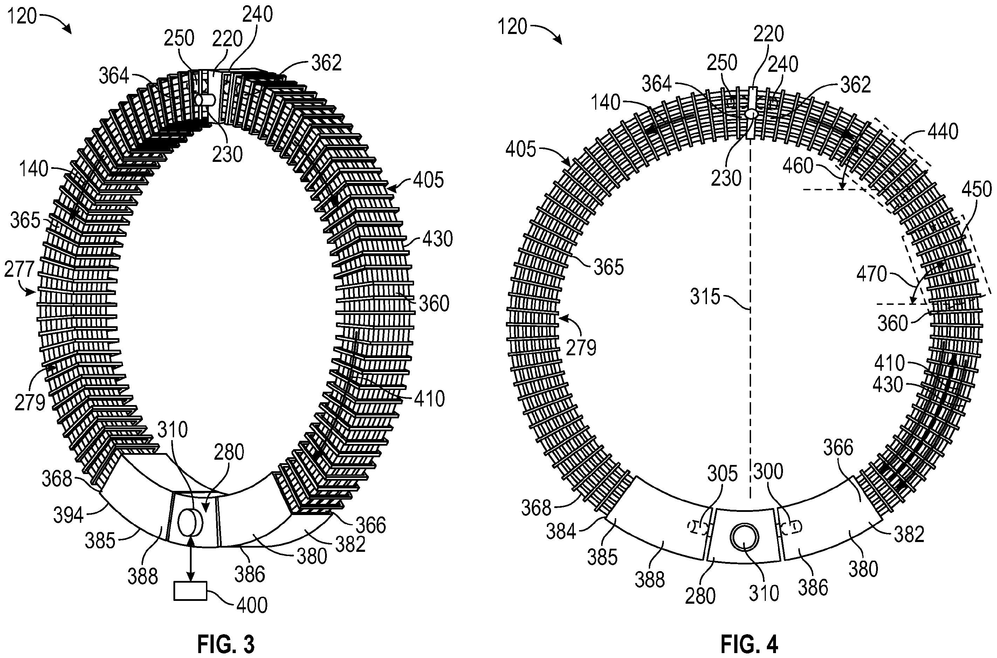

The heat exchanger 120 may include an inlet manifold 220 configured to receive the cooling fluid 140. The inlet manifold 220 may define a manifold inlet 230 that is configured to receive the cooling fluid 140 from the external cooling circuit 130. First and second manifold outlets 240, 250 (FIGS. 3, 4), may be respectively configured to direct first and second flow portions 260, 270 (FIGS. 3, 4, shown schematically) downstream into the heat exchanger 120 as indicated below.

First and second condenser arms 360, 365 (FIGS. 3, 4) may be respectively connected to the first and second manifold outlets 240, 250. Specifically, the first and second condenser arms 360, 365 may respectively extend from first and second condenser inlets 362, 364 to first and second condenser outlets 366, 368.

The first and second condenser arms 360, 365 may include one or more fluid conduction passageways 405 that extend between first and second condenser inlets and outlets. The fluid conduction passageways 405 may include exterior heat fins 430 the formed from plates 412 that define the first and second passageways 405. Alternatively, the passageways 405 are tubes 410 (FIG. 3, 4, shown schematically in the first condenser 360 for simplicity) that form coolant channels and the fins contact and extend outwardly from the tubes 410. In one embodiment, the tubes 410 may form a single pass channel (shown schematically in FIG. 3). In one embodiment, the tubes 410 may form a multi-pass channel 410 (shown schematically in FIG. 4). A configuration of the tubes 410 may depend on the amount of cooling required to change the cooling fluid 140 from vapor to liquid in the first condenser 360. While a single channel is shown, it should be understood that the tubes could be formed of multiple separated paths (e.g., multiple tubes or passageways). In one embodiment, the heat exchanger 120 is a tube-fin heat exchanger. In another embodiment, the heat exchanger 120 may be a plate-fin heat exchanger. The heat exchanger 120 may be formed from an additive manufacturing process.

First and second reservoirs 380, 385 may be respectively connected to the first and second condenser arms 360, 365. Specifically, the first and second reservoirs 380, 385 may respectively extend from first and second reservoir inlets 382, 384 to first and second reservoir outlets 386, 388. From this configuration, fluid received at the inlet manifold 220 travels from the inlet manifold 220 into the first and second reservoirs 380, 385 via the first and second condenser arms 360, 365.

An outlet pump 280 is located circumferentially between the first and second reservoirs 380, 385, i.e., between the first and second reservoirs 380, 385 relative to an outer boundary 279 that defines a perimeter of the heat exchanger 120. The outlet pump 280 may include first and second pump inlets 300, 305 (FIG. 4) respectively connected to the first and second reservoir outlets 386, 388. A pump outlet port 310 of the outlet pump 280 may be configured to direct the cooling fluid 140 towards the external cooling circuit 130. In the disclosed embodiments, the external cooling circuit 130 (FIG. 2) may extend from the pump outlet port 310, though the motor 50, and into the manifold inlet 230. In one embodiment, the outlet pump 280 alone provides sufficient pressure to drive (e.g. from negative pressure, or suction, created on the inlet side of the pump) the coolant through the heat exchanger 120. In one embodiment, flow is gravity assisted, or gravity driven, with the inlet manifold 220 located above the outlet pump 280 relative to a direction of gravity.

The heat exchanger 120 may be an air-cooled heat exchanger, e.g., cooled by an airflow 275 (FIG. 2), e.g., impinging against a front side 277 of the heat exchanger 120 (FIG. 1). In an aircraft 10 (FIG. 1), such airflow 275 may be provided by RAM air, or may be provided by an onboard fan, for example. The heat exchanger 120 also may be utilized in non-flight commercial or residential systems to cool a variety of types of equipment, such as a heating, ventilation, air-conditioning (HVAC) system. The cooling fluid 140 as more fully shown below may be a two-phase cooling fluid.

With the heat exchanger 120, the cooling fluid 140 enters the heat exchanger as a vapor or a combination of vapor and liquid at the inlet manifold 220. As the cooling fluid is drawn through the condenser arms, heat is removed from it. This removal of heat causes the cooling fluid 140 to condense to a liquid phase through the first and second condenser arms 360, 365 and collects as liquid in the first and second reservoirs 380, 385. The first and second reservoirs 380, 385 feed the outlet pump 280, and the pump outlet port 310 feeds the external cooling circuit 130, which is directed to the motor 50 or other components to be cooled. The arrangement provides for a compact packaging and ensures the outlet pump 280 has available pressure to pump the near-saturated liquid, for example, without cavitating.

To prevent the outlet pump 280 from running dry, which may damage the outlet pump 280, the first reservoir 380 may be sized to capture a predetermined volume of condensed fluid from the cooling fluid 140. In one embodiment, the outlet pump 280, to prevent the outlet pump 280 from running dry, the outlet pump 280 may be configured to disengage when a characteristic of the cooling fluid 140 crosses a threshold. For example, the outlet pump 280 may be configured to disengage when a temperature of the cooling fluid 140 is above a threshold. In another embodiment, the outlet pump 280 may be configured to disengage when a pressure of the cooling fluid 140 drops below a threshold. Either of these characteristics may be indicative of an availability of a lower than a minimal amount of a liquid phase of the cooling fluid 140 between the reservoirs to run the outlet pump 280 without causing damage.

In addition, in one embodiment, the outlet pump 280 may be a variable speed pump, enabling the outlet pump 280 to provide a constant pressure through the external cooling circuit 130. In one embodiment, a valve 400 (FIG. 3) may be in fluid communication with the outlet pump 280, e.g., with the pump outlet port 310. The valve 400 may be configured to control the cooling fluid 140 through it when a characteristic of the cooling fluid 140 crosses a threshold; for example, when the temperature of the coolant in reservoir exceeds a certain value or a level of subcooling (e.g., formation of liquid) at the pump inlet drops below a certain threshold.

As shown in FIG. 2, the heat exchanger 120 may be surround and be radially outward from the motor 50 and may be configured with a compact size relative to the motor 50. The heat exchanger 120 can contact the motor or be spaced from it.

As shown in FIGS. 2-4, the heat exchanger 120, via the inlet manifold 220, the first and second reservoirs 380, 385, the first and second condenser arms 360, 365, in combination, may form a continuous shape. The continuous shape may be defined by the outer boundary 279 that is symmetrical about an axis 315 (FIG. 4) extending between the inlet manifold 220 to the outlet pump 280. As shown in FIGS. 2-4, the heat exchanger 120 may be shaped as a ring or annulus. Thus, each condenser-reservoir pair may be formed as continuous arcs, e.g., with a semi-annular shape. It is to be appreciated that a ring shape is one of many available shape options. For example, each of the first and second condenser arms 360, 365 may be divided into segments 440, 450 disposed at segmentation angles 460, 470 as shown schematically with the first condenser 360 in FIG. 4. The formation and distribution of the segments 440, 450 may be such that the resulting configuration is similar to the ring shape or other desired shape. The compact sizing of the heat exchanger 120 may enable a packaging of it that is convenient for residential or commercial applications where a storage area may be limited.

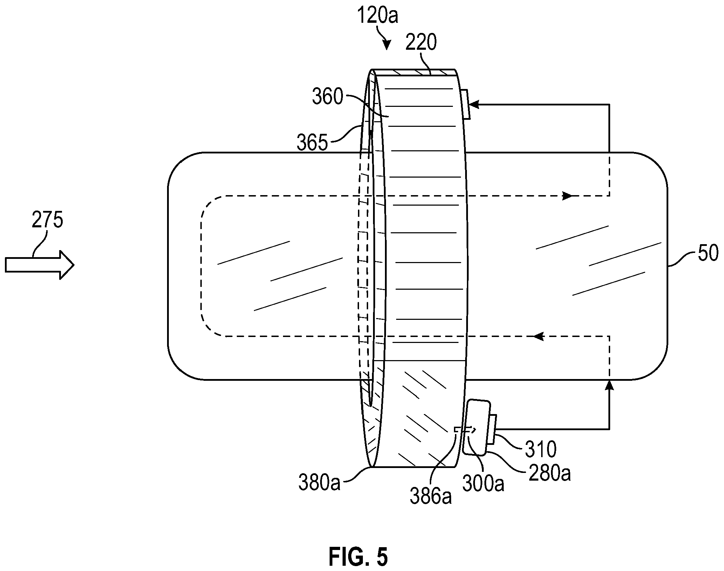

FIG. 5 shows another embodiment of the heat exchanger 120a. Elements of the heat exchanger 120a that are not labeled in FIG. 5 are the same as those in the heat exchanger 120 of FIGS. 2-4. For example, the condenser arms 360, 365, cooled by air 275, and manifold 220 are the same as those components discussed with FIGS. FIGS. 2-4. In addition, the heat exchanger 120a of FIG. 5 connects with the motor 50a in the same way as the heat exchanger 120 of FIGS. 2-4. In the embodiment of FIG. 5, a continuous reservoir 380a is provided rather than the two reservoirs 380, 385 (FIGS. 2-4). The continuous reservoir 380a may be arc shaped to form a semicircular c-shape (or U-shape) along its front or rear profile. The reservoir 380a may have a single outlet port 386a (shown schematically) that feeds a single pump inlet port 300a (shown schematically) of the pump 280a for this embodiment. As shown, the pump 280a may be located axially ahead or aft of the reservoir 380a (shown in the aft location in FIG. 5). The pump 280a has the single outlet 310 and functions the same as the pump 280 discussed in FIGS. 2 through4.

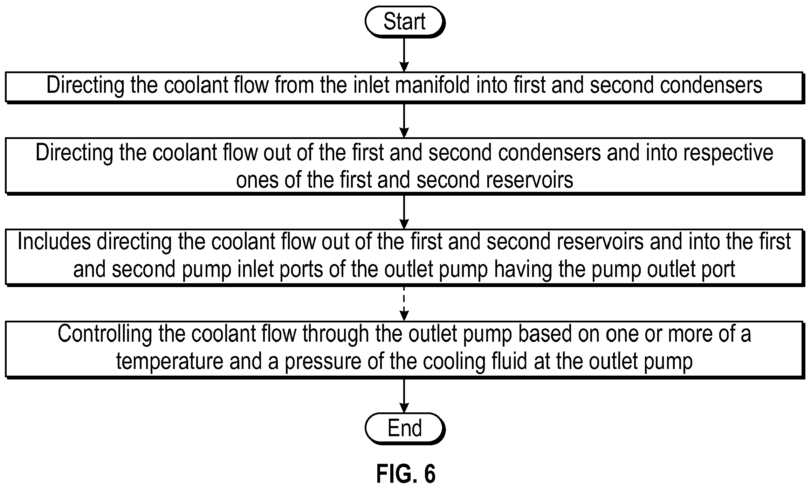

Turning to FIG. 6, a flowchart shows a method of directing a cooling fluid 140 (e.g. a fluid) through the heat exchanger 120 shown in FIGS. 2-4. As shown in block 500, the method includes directing the cooling fluid 140 from the inlet manifold 220 into first and second condenser arms 360, 365. As indicated above, this includes directing the cooling fluid 140 out of the first and second manifold outlet ports 240, 250 of the inlet manifold 220 and into respective ones of the first and second condenser inlets 362, 364 of the first and second condenser arms 360, 365.

As shown in block 510, the method includes directing the cooling fluid 140 out of the first and second condenser arms 360, 365 and into respective ones of the first and second reservoirs 380, 385. As indicated above, this includes directing the cooling fluid 140 out of first and second condenser outlets 366, 368 of the first and second condenser arms 360, 365 and into respective ones of the first and second reservoir inlets 382, 384 of the first and second reservoirs 380, 385.

As shown in block 520, the method includes directing the cooling fluid 140 out of the first and second reservoirs 380, 385 and into the first and second pump inlet ports 300, 305 of the outlet pump 280 having the pump outlet port 310. As shown in block 530, the method may also optionally include controlling the flow of the cooling fluid 140 through the outlet pump 280 based on one or more of a temperature and a pressure of the cooling fluid 140 or a combination of the two indicative of the level of subcooling at pump 280 inlet or superheating at the condenser inlets.

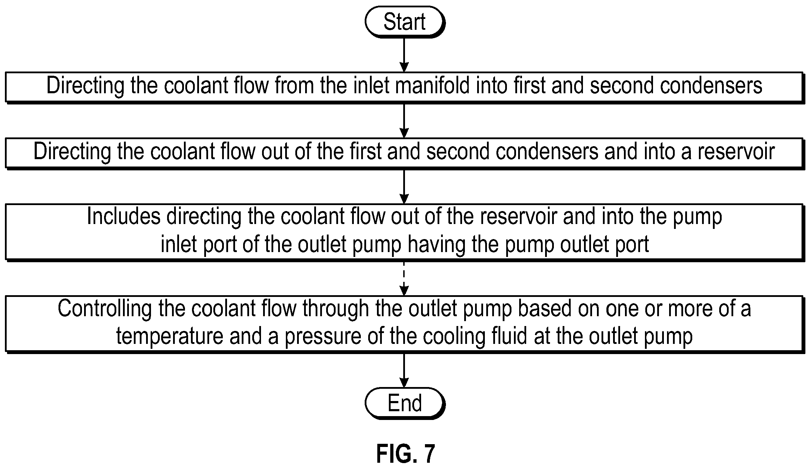

Turning to FIG. 7, a flowchart shows a method of directing a cooling fluid 140 (e.g. a fluid) through the heat exchanger 120a shown in FIG. 5. Aspects not expressly identified with respect to FIG. 7 are the same as those in FIG. 6. As shown in block 600, the method includes directing the cooling fluid 140 from the inlet manifold 220 into first and second condenser arms 360, 365. As shown in block 610, the method includes directing the cooling fluid 140 out of the first and second condenser arms 360, 365 and into the reservoir 380a. As shown in block 620, the method includes directing the cooling fluid 140 out of the reservoir 380a and into the pump inlet port 300a of the outlet pump 280a having the pump outlet port 310. As shown in block 630, the method may also optionally include controlling the flow of the cooling fluid 140 through the outlet pump 280a based on one or more of a temperature and a pressure of the cooling fluid 140 or a combination of the two indicative of the level of subcooling at pump 280a inlet or superheating at the condenser inlets.

The above disclosed embodiments provide machines, including aviation-class electric motor and drives, with a two-phase heat exchanger 120 that may be configured to fit within a relatively small storage space around or adjacent to the machinery. It is to be appreciated that the heat exchanger may be implemented with an environmental control system (ECS) of an aircraft, or other implantation in which the apparatus/structure to be cooled is not configured with moving parts.

The terminology used herein is for the purpose of describing particular embodiments only and is not intended to be limiting of the present disclosure. As used herein, the singular forms "a", "an" and "the" are intended to include the plural forms as well, unless the context clearly indicates otherwise. It will be further understood that the terms "comprises" and/or "comprising," when used in this specification, specify the presence of stated features, integers, steps, operations, elements, and/or components, but do not preclude the presence or addition of one or more other features, integers, steps, operations, element components, and/or groups thereof.

While the present disclosure has been described with reference to an exemplary embodiment or embodiments, it will be understood by those skilled in the art that various changes may be made without departing from the scope of the invention as defined by the claims. In addition, many modifications may be made to adapt a particular situation or material to the teachings of the present disclosure without departing from the scope of the claims. Therefore, it is intended that the present disclosure not be limited to the particular embodiment disclosed as the best mode contemplated for carrying out this present disclosure, but that the present disclosure will include all embodiments falling within the scope of the claims.

## Claims

1. A heat exchanger comprising:
an inlet manifold (220) configured to receive a cooling fluid;
a reservoir (380);
first and second condenser arms (360, 365) connected between, and respectively fluidly coupling, the inlet manifold and the reservoir, so that fluid received at the inlet manifold travels from the inlet manifold into the reservoir; and
an outlet pump (280) having a pump inlet port (300) coupled to the reservoir and having a pump outlet port,
**characterized in that**
the inlet manifold, the reservoir, the first and second condensers, in combination, form a continuous shape.

2. The heat exchanger of claim 1, wherein gravity, suction created by the pump or a combination of both draws the cooling fluid from the inlet manifold, through the condenser arms and into the reservoir.

3. The heat exchanger of claim 1 or 2, wherein:
the inlet manifold includes a manifold inlet port and first and second manifold outlet ports;
the first and second condenser arms respectively extend from first and second condenser inlets to first and second condenser outlets; and
wherein the first and second condenser inlets are fluidly coupled to respective ones of the first and second manifold inlet ports.

4. The heat exchanger of claim 3, wherein:
the reservoir extends from first and second reservoir inlets to a reservoir outlet; and
the first and second reservoir inlets are fluidly coupled to respective ones of the first and second condenser outlets.

5. The heat exchanger of claim 4, wherein
the pump inlet port is fluidly coupled to the reservoir outlet.

6. The heat exchanger of claim 5, wherein
the first and second condenser arms include one or more fluid conduction passageways (405) that respectively extend between the first and second condenser inlets and the first and second condenser outlets, and optionally wherein
one or more of the inlet manifold, the condenser arms and the reservoir are formed by an additive manufacturing process.

7. The heat exchanger of claim 6, wherein
the fluid conduction passageways include fins (430), and optionally wherein
the fins are formed from plates that define the first and second passageways or wherein the passageways are tubes and the fins contact and extend outwardly from the tubes.

8. The heat exchanger of any preceding claim, wherein
the heat exchanger is symmetric about an axis extending between the inlet manifold and the outlet pump.

9. The heat exchanger of any preceding claim, wherein
the continuous shape of the heat exchanger is a ring shape and/or wherein
the outlet pump is a variable speed pump.

10. The heat exchanger of any preceding claim, wherein
the outlet pump is configured to disengage when a temperature of the cooling fluid at the pump inlet port is above a threshold or when a pressure of the cooling fluid is below a threshold, and optionally further comprising:
a valve (400) in fluid communication with the outlet pump, wherein the valve is configured to control the cooling fluid through it when a characteristic of the cooling fluid crosses a threshold.

11. The heat exchanger of any preceding claim, wherein
the reservoir defines first and second reservoirs that respectively have first and second reservoir outlets, and the pump is circumferentially disposed between the first and second reservoirs and fluidly coupled to the first and second reservoir outlets

12. An aircraft comprising:
a motor (50);
a motor cooling circuit extending through the motor; and
a heat exchanger (120) as claimed in any preceding claim.

13. A method of directing fluid in a heat exchanger, comprising:
directing a cooling fluid from an inlet manifold (220) into first and second condenser arms (360, 365);
directing the cooling fluid out of the first and second condenser arms and into respective ones of first and second reservoirs (380, 385); and
directing the cooling fluid out of the first and second reservoirs and into an inlet port (300) of an outlet pump (280) having a pump outlet port,
wherein the inlet manifold, the first and second reservoirs, the first and second condenser arms, in combination, form a continuous shape.

14. The method of claim 13, wherein
directing the cooling fluid from the inlet manifold into the first and second condenser arms includes:
directing the cooling fluid out of first and second manifold outlet ports of the inlet manifold and into respective ones of first and second condenser inlets of the first and second condenser arms, and optionally wherein
directing the cooling fluid out of the first and second condenser arms and into the reservoir includes:
directing the cooling fluid out of first and second condenser outlets of the first and second condenser arms and into first and second reservoir inlets of the reservoir.

15. The method of claim 13 or 14, further comprising:
controlling the cooling fluid through the outlet pump based on one or more of a temperature and a pressure of the cooling fluid at the outlet pump.

## Patentansprüche

1. Wärmetauscher, umfassend:
einen Einlassverteiler (220), der dazu konfiguriert ist, ein Kühlfluid zu empfangen;
einen Behälter (380);
einen ersten und einen zweiten Kondensatorarm (360, 365), die zwischen dem Einlassverteiler und dem Behälter verbunden sind bzw. diese fluidkoppeln, sodass am Einlassverteiler empfangenes Fluid aus dem Einlassverteiler in den Behälter gelangt; und
eine Auslasspumpe (280), die einen Pumpeneinlassanschluss (300), der mit dem Behälter gekoppelt ist, und einem Pumpenauslassanschluss aufweist,
**dadurch gekennzeichnet, dass** der Einlassverteiler, der Behälter, der erste und der zweite Kondensator in Kombination eine kontinuierliche Form bilden.

2. Wärmetauscher nach Anspruch 1, wobei die Schwerkraft, der von der Pumpe erzeugte Sog oder eine Kombination aus beidem das Kühlfluid aus dem Einlassverteiler durch die Kondensatorarme in den Behälter saugt.

3. Wärmetauscher nach Anspruch 1 oder 2, wobei:
der Einlassverteiler einen Verteilereinlassanschluss und einen ersten und einen zweiten Verteilerauslassanschluss beinhaltet;
der erste und der zweite Kondensatorarm sich jeweils von dem ersten und dem zweiten Kondensatoreinlass zu dem ersten und dem zweiten Kondensatorauslass erstrecken; und
wobei der erste und der zweite Kondensatoreinlass jeweils mit dem ersten bzw. dem zweiten Verteilereinlassanschluss fluidgekoppelt sind.

4. Wärmetauscher nach Anspruch 3, wobei:
der Behälter sich von einem ersten und einem zweiten Behältereinlass zu einem Behälterauslass erstreckt; und
der erste und der zweite Behältereinlass jeweils mit dem ersten bzw. dem zweiten Kondensatorauslass fluidgekoppelt sind.

5. Wärmetauscher nach Anspruch 4, wobei
der Pumpeneinlassanschluss mit dem Behälterauslass fluidgekoppelt ist.

6. Wärmetauscher nach Anspruch 5, wobei
der erste und der zweite Kondensatorarm einen oder mehrere Fluidleitungskanäle (405) beinhalten, die sich jeweils zwischen dem ersten und dem zweiten Kondensatoreinlass und dem ersten und dem zweiten Kondensatorauslass erstrecken, und wobei optional
einer oder mehrere des Einlassverteilers, der Kondensatorarme und des Behälters durch ein additives Fertigungsverfahren gebildet werden.

7. Wärmetauscher nach Anspruch 6, wobei
die Fluidleitungskanäle Rippen (430) beinhalten, und wobei optional
die Rippen aus Platten gebildet sind, die den ersten und den zweiten Kanal definieren, oder wobei die Kanäle Rohre sind und die Rippen die Rohre berühren und sich von diesen nach außen erstrecken.

8. Wärmetauscher nach einem der vorhergehenden Ansprüche, wobei der Wärmetauscher symmetrisch um eine Achse ist, die sich zwischen dem Einlassverteiler und der Auslasspumpe erstreckt.

9. Wärmetauscher nach einem der vorhergehenden Ansprüche, wobei die kontinuierliche Form des Wärmetauschers eine Ringform ist und/oder wobei
die Auslasspumpe eine Pumpe mit variabler Drehzahl ist.

10. Wärmetauscher nach einem der vorhergehenden Ansprüche, wobei die Auslasspumpe dazu konfiguriert, sich zu deaktivieren, wenn eine Temperatur des Kühlfluids an dem Pumpeneinlassanschluss über einem Schwellenwert liegt oder wenn ein Druck des Kühlfluids unter einem Schwellenwert liegt, und optional ferner umfassend:
ein Ventil (400) in Fluidverbindung mit der Auslasspumpe, wobei das Ventil dazu konfiguriert ist, das hindurchfließende Kühlfluid zu steuern, wenn ein Merkmal des Kühlfluids einen Schwellenwert überschreitet.

11. Wärmetauscher nach einem der vorhergehenden Ansprüche, wobei der Behälter einen ersten und einen zweiten Behälter definiert, die jeweils einen ersten und einen zweiten Behälterauslass aufweisen, und die Pumpe kreisförmig zwischen dem ersten und dem zweiten Behälter angeordnet und mit dem ersten und dem zweiten Behälterauslass fluidgekoppelt ist.

12. Flugzeug, umfassend:
einen Motor (50);
einen Motorkühlkreislauf, der sich durch den Motor erstreckt; und
einen Wärmetauscher (120) nach einem der vorhergehenden Ansprüche.

13. Verfahren zum Leiten von Fluid in einem Wärmetauscher, umfassend:
Leiten eines Kühlfluids aus einem Einlassverteiler (220) in einen ersten und einen zweiten Kondensatorarm (360, 365);
Leiten des Kühlfluids aus dem ersten und dem zweiten Kondensatorarm jeweils in einen ersten bzw. einen zweiten Behälter (380, 385); und
Leiten des Kühlfluids aus dem ersten und dem zweiten Behälter in einen Einlassanschluss (300) einer Auslasspumpe (280), die einen Pumpenauslassanschluss aufweist,
wobei der Einlassverteiler, der erste und der zweite Behälter sowie der erste und der zweite Kondensatorarm in Kombination eine kontinuierliche Form bilden.

14. Verfahren nach Anspruch 13, wobei
das Leiten des Kühlfluids aus dem Einlassverteiler in den ersten und den zweiten Kondensatorarm Folgendes beinhaltet:
Leiten des Kühlfluids aus einem ersten und einem zweiten Verteilerauslassanschluss des Einlassverteilers jeweils in einen ersten bzw. einen zweiten Kondensatoreinlass des ersten und des zweiten Kondensatorarms, und wobei optional
das Leiten des Kühlfluids aus dem ersten und dem zweiten Kondensatorarm in den Behälter Folgendes beinhaltet:
Leiten des Kühlfluids aus einem ersten und einem zweiten Kondensatorauslass des ersten und des zweiten Kondensatorarms in den ersten und den zweiten Behältereinlass des Behälters.

15. Verfahren nach Anspruch 13 oder 14, ferner umfassend:
Steuern des Kühlfluids durch die Auslasspumpe basierend auf einem oder mehreren einer Temperatur und eines Drucks des Kühlfluids an der Auslasspumpe.

## Revendications

1. Échangeur de chaleur, comprenant :
un collecteur d'admission (220) configuré pour recevoir un fluide de refroidissement ;
un réservoir (380) ;
un premier et un second bras de condenseur (360, 365) reliés entre, et couplant respectivement de manière fluidique, le collecteur d'admission et le réservoir, de sorte que le fluide reçu au niveau du collecteur d'admission se déplace du collecteur d'admission vers le réservoir ; et
une pompe de sortie (280) présentant un orifice d'entrée de pompe (300) couplé au réservoir et présentant un orifice de sortie de pompe,
**caractérisé en ce que** le collecteur d'admission, le réservoir, le premier et le second condenseurs, en combinaison, forment une forme continue.

2. Échangeur de chaleur selon la revendication 1, dans lequel la gravité, l'aspiration créée par la pompe ou une combinaison des deux aspire le fluide de refroidissement depuis le collecteur d'admission, à travers les bras du condenseur et dans le réservoir.

3. Échangeur de chaleur selon la revendication 1 ou 2, dans lequel :
le collecteur d'admission inclut un orifice d'admission de collecteur et un premier et un second orifices de sortie de collecteur ;
le premier et le second bras de condenseur se prolongent respectivement de la première et de la seconde,entrées de condenseur à la première et à la seconde sorties de condenseur ; et
dans lequel la première et la seconde entrées de condenseur sont couplées de manière fluidique à des orifices respectifs du premier et du second orifices d'entrée de collecteur.

4. Échangeur de chaleur selon la revendication 3, dans lequel :
le réservoir se prolonge depuis la première et la seconde entrées du réservoir jusqu'à une sortie du réservoir ; et
la première et la seconde entrées de réservoir sont couplées de manière fluidique à celles respectives de la première et de la seconde sorties de condenseur.

5. Échangeur de chaleur selon la revendication 4, dans lequel l'orifice d'entrée de la pompe est couplé de manière fluidique à la sortie du réservoir.

6. Échangeur de chaleur selon la revendication 5, dans lequel
le premier et le second bras de condenseur incluent un ou plusieurs passages de conduction de fluide (405) qui se prolongent respectivement entre la première et la seconde entrées de condenseur et la première et la seconde sorties de condenseur, et éventuellement dans lequel
l'un ou plusieurs des collecteurs d'admission, des bras du condenseur et du réservoir sont formés par un procédé de fabrication additive.

7. Échangeur de chaleur selon la revendication 6, dans lequel les passages de conduction de fluide incluent des ailettes (430), et éventuellement dans lesquels
les ailettes sont formées de plaques qui définissent le premier et le second passages ou dans lesquelles les passages sont des tubes et les ailettes entrent en contact et se prolongent vers l'extérieur à partir des tubes.

8. Échangeur de chaleur selon une quelconque revendication précédente, dans lequel
l'échangeur de chaleur est symétrique autour d'un axe se prolongeant entre le collecteur d'admission et la pompe de sortie.

9. Échangeur de chaleur selon une quelconque revendication précédente, dans lequel
la forme continue de l'échangeur de chaleur est une forme annulaire et/ou dans laquelle
la pompe de sortie est une pompe à vitesse variable.

10. Échangeur de chaleur selon une quelconque revendication précédente, dans lequel
la pompe de sortie est configurée pour se désengager lorsqu'une température du fluide de refroidissement au niveau de l'orifice d'entrée de la pompe est supérieure à un seuil ou lorsqu'une pression du fluide de refroidissement est inférieure à un seuil, et comprenant éventuellement également :
une vanne (400) en communication fluidique avec la pompe de sortie, dans lequel la vanne étant configurée pour contrôler le fluide de refroidissement à travers elle lorsqu'une caractéristique du fluide de refroidissement franchit un seuil.

11. Échangeur de chaleur selon une quelconque revendication précédente, dans lequel
le réservoir définit un premier et un second réservoirs qui présentent respectivement une première et une seconde sorties de réservoir, et la pompe est disposée de manière circonférentielle entre le premier et le second réservoirs et couplée de manière fluidique à la première et à la seconde sorties de réservoir.

12. Aéronef comprenant :
un moteur (50) ;
un circuit de refroidissement du moteur se prolongeant à travers le moteur ; et
un échangeur de chaleur (120) selon une quelconque revendication précédente.

13. Procédé de direction de fluide dans un échangeur de chaleur, comprenant :
la direction d'un fluide de refroidissement depuis un collecteur d'admission (220) dans le premier et le second bras de condenseur (360, 365) ;
la direction du fluide de refroidissement hors du premier et du second bras de condenseur et dans le premier et le second réservoirs respectifs (380, 385) ; et
la direction du fluide de refroidissement hors du premier et du second réservoirs et dans un orifice d'entrée (300) d'une pompe de sortie (280) présentant un orifice de sortie de pompe,
dans lequel le collecteur d'admission, le premier et le second réservoirs, le premier et le second bras de condenseur, en combinaison, forment une forme continue.

14. Procédé selon la revendication 13, dans lequel la direction du fluide de refroidissement du collecteur d'admission vers le premier et le second bras du condenseur inclut :
la direction du fluide de refroidissement hors du premier et du second orifices de sortie du collecteur d'admission et dans la première et la seconde entrées respective du premier et du second bras du condenseur, et éventuellement dans lequel
la direction du fluide de refroidissement hors du premier et du second bras du condenseur et dans le réservoir inclut :
la direction du fluide de refroidissement hors de la première et de la seconde sorties du condenseur du premier et du second bras du condenseur et dans la première et la seconde entrées de réservoir du réservoir.

15. Procédé selon la revendication 13 ou 14, comprenant également :
le contrôle du fluide de refroidissement à travers la pompe de sortie sur la base de l'une ou plusieurs de températures et pressions du fluide de refroidissement au niveau de la pompe de sortie.
